# EUROPÄISCHE PATENTSCHRIFT

(11) **EP 3 250 931 B1**
(45) Veröffentlichungstag und Bekanntmachung des Hinweises auf die Patenterteilung: **28.11.2018**
(21) Anmeldenummer: 16701776.3
(22) Anmeldetag: 27.01.2016
(51) Int. Cl.: G01P 15/125, B81B 3/00, G01P 15/08

(54) **BESCHLEUNIGUNGSSENSOR MIT FEDERKRAFTKOMPENSATION**
ACCELERATION SENSOR HAVING SPRING FORCE COMPENSATION
CAPTEUR D'ACCÉLÉRATION À COMPENSATION DE LA FORCE DE RESSORT

(30) Priorität: 29.01.2015 DE 102015001128
(43) Veröffentlichungstag der Anmeldung: 06.12.2017
(73) Patentinhaber: Northrop Grumman LITEF GmbH, 79115 Freiburg (DE)
(72) Erfinder: KÖNIG, Stefan, 79219 Staufen (DE); LEINFELDER, Peter, 79238 Ehrenkirchen (DE)
(74) Vertreter: Müller Hoffmann & Partner
(86) Internationale Anmeldenummer: PCT/EP2016/051693
(87) Internationale Veröffentlichungsnummer: WO 2016/120319

(56) Entgegenhaltungen:
- WO-A1-94/28427
- WO-A1-97/44675
- WO-A1-2015/052487
- DE-A1-102009 046 807
- US-A1- 2005 001 275
- US-A1- 2014 165 691

## Beschreibung

Die Erfindung bezieht sich auf einen Beschleunigungssensor mit Federkraftkompensation.

In verschiedenen Anwendungen kommen Beschleunigungssensoren zum Messen von Beschleunigungen zum Einsatz. Dabei wird häufig eine Massenkomponente mittels Federelementen über einem Substrat gelagert, deren Auslenkung bei einer anliegenden Beschleunigung gemessen wird. Um die Empfindlichkeit und damit die Sensitivität gegenüber Beschleunigungen zu steigern, ist es erstrebenswert, die Federsteife der Federn möglichst gering zu halten, ohne dass dabei andere Eigenschaften wie Schockfestigkeit oder Empfindlichkeit auf Querbeschleunigungen verändert werden. Eine Reduktion ist durch die verwendeten Fertigungstechnologien jedoch begrenzt und in der Regel bereits ausgeschöpft.

Die WO 94/28427 A1 beschreibt einen mikro-elektro-mechanischen Beschleunigungssensor mit einer beweglichen Testmasse, die von Federn gestützt wird, die eine kontrollierbare Federhärte aufweisen.

Die US 2005/0001275 A1 beschreibt einen Beschleunigungssensor mit einer von Federn gehaltenen Testmasse, wobei die Federhärte der Federn mittels Elektroden eingestellt werden kann.

Die WO 97/44675 A1 beschreibt einen Vibrationsüberträger, in dem Vibrationen mittels beidseitig eines Vibrationsbalkens angeordneten Elektroden angeregt werden kann.

Die WO 2014/177243 A1 beschreibt einen mikro-elektro-mechanischen Beschleunigungssensor mit als Kammelektroden ausgebildeten Sensorelektroden. Gegenüber den Rückseiten der Sensorelektroden, die Elektrodenfinger der Kammelektroden tragen, sind Schirmelektroden zur pneumatischen Dämpfung der Testmasse angeordnet. Diese Schirmelektroden sind mit der Testmasse auf ein gleiches elektrisches Potential gelegt, damit es zu keinen ungewollten elektrostatischen Kräften zwischen den Schirmelektroden und den jeweiligen gegenüberliegenden beweglichen Kammelektroden kommt.

Der Erfindung liegt die Aufgabe zugrunde, einen Beschleunigungssensor mit geringer effektiver Federsteife oder Federhärte anzugeben.

Die Aufgabe wird gelöst durch den Gegenstand der unabhängigen Patentansprüche. Weiterbildungen sind durch die abhängigen Patentansprüche definiert.

Ein Beschleunigungssensor weist auf: eine Sensormasse, die mittels Federelementen entlang einer Bewegungsachse beweglich über einem Substrat gelagert ist; erste Trimmelektroden, die mit der Sensormasse verbunden sind; und zweite Trimmelektroden, die mit dem Substrat verbunden sind und den ersten Trimmelektroden zugeordnet sind. Dabei wird durch die Federelemente bei Auslenkung der Sensormasse entlang der Bewegungsachse eine Federkraft auf die Sensormasse und durch Anlegen einer elektrischen Trimmspannung zwischen den ersten Trimmelektroden und den zweiten Trimmelektroden bei Auslenkung der Sensormasse eine elektrostatische Kraft auf die Sensormasse erzeugt, die der Federkraft entgegenwirkt.

Durch die elektrische Trimmspannung zwischen den ersten und den zweiten Trimmelektroden wird bei Auslenkung der Sensormasse sowohl eine Federkraft auf die Sensormasse als auch eine elektrostatische Kraft erzeugt, die der Federkraft entgegenwirkt. Da die entgegenwirkende elektrostatische Kraft stets dann erzeugt wird, wenn auch die Federkraft erzeugt wird, kommt es zu einer Kompensation der beiden Kräfte, wodurch die effektive Federkonstante des Systems, die sich aus der Federkonstante der Federelemente und der Federkonstante der ten Symmetrieachse auf dem Substrat angebracht sein. Durch eine solche völlig symmetrisch gestaltete Anordnung der Trimmelektroden kann keine resultierende Kraft auf die Trimmelektroden entstehen, solange die Sensormasse nicht ausgelenkt ist. Damit wird gewährleistet, dass das Vorhandensein der ersten und der zweiten Trimmelektroden das Auslesen des Beschleunigungssensors nicht verzerrt, sondern nur zu einer freien Einstellbarkeit der Federhärte des Beschleunigungssensors dient. Zudem kann durch eine solche Anordnung die Wirkung von Herstellungstoleranzen reduziert werden.

Die von den ersten Trimmelektroden und den zweiten Trimmelektroden erzeugte elektrostatische Kraft kann gleich der von den Federelementen erzeugten Federkraft sein. Dadurch wird gewährleistet, dass selbst bei einer Auslenkung der Sensormasse effektiv keine Kraft auf die Sensormasse wirkt, die diese in die Ausgangslage zurücktreibt. Die Sensormasse kann dadurch mit Bezug auf eventuell vorhandene Anrege- und Detektionselektroden frei positioniert werden. Dies erlaubt es, Verzerrungen im Messverhalten, die durch Fertigungstoleranzen hervorgerufen werden (Bias) zu reduzieren oder gänzlich zu vermeiden.

Ein Teil der ersten Trimmelektroden kann als Kammelektroden ausgebildet sein und die zweiten Trimmelektroden können als Elektrodenplatten ausgebildet sein. Der Teil der als Kammelektroden ausgebildeten Trimmelektroden, der Elektrodenfinger der Kammelektroden trägt, und die zweiten Trimmelektroden bilden dann einen Plattenkondensator, der zur Erzeugung der elektrostatischen Kraft dient. Durch eine solche Anordnung ist es möglich, die ersten Trimmelektroden neben der Erzeugung der elektrostatischen Kraft, die der Federkraft entgegenwirkt, auch für weitere Zwecke, wie etwa die Beschleunigungsdetektion, zu verwenden. Dadurch ist es möglich, den Beschleunigungssensor kompakter auszubilden.

Ein Teil der ersten Trimmelektroden kann als Elektrodenplatten ausgebildet sein und die ersten Trimmelektroden, die als Elektrodenplatten ausgebildet sind können mit den zugeordneten zweiten Trimmelektroden Plattenkondensatoren bilden. Dies erlaubt es, die ersten Trimmelektroden und die zweiten Trimmelektroden einfach zu fertigen, wodurch Beschleunigungssensoren, deren Federhärte frei einstellbar ist, leicht und günstig herstellbar sind.

Die Sensormasse kann durch Einstellen der Detektionsspannung in einer neutralen Position gehalten werden, in der die gemessene Beschleunigung unabhängig von der Trimmspannung ist. Die tatsächlich anliegende Beschleunigung ist dabei irrelevant. Dadurch wird gewährleistet, dass unabhängig von der anliegenden Trimmspannung eine gewisse Beschleunigung Sensormassegemessen wird. Diese Beschleunigung kann über die Detektions- und Sensorelektroden bestimmt werden und bildet zusammen mit der neutralen Position ein Parameterpaar, das charakteristisch für den verwendeten Beschleunigungssensor ist. Zum Beispiel kann aus dem aus neutraler Position und dazugehöriger Beschleunigung bestehenden Parameterpaar bestimmt werden, ob die Lage oder Form der Trimmelektroden stabil ist oder ob der Beschleunigungssensor beschädigt ist. Dadurch kann die Verlässlichkeit des Beschleunigungssensors erhöht werden.

Eine Recheneinheit kann aus der neutralen Position eine Abweichung einer ersten Stellung der Sensormasse, in der keine Federkraft auf die Sensormasse wirkt, von einer zweiten Stellung der Sensormasse bestimmen, in der keine von den Sensorelektroden und Detektionselektroden erzeugte Kraft auf die Sensormasse wirkt. Dadurch wird es möglich über die Bestimmung der neutralen Position festzustellen, ob durch Fertigungstoleranzen hervorgerufene Abweichungen des mechanischen Nullpunkts (d.h. der Stellung der Sensormasse ohne Federkraft) und des elektrischen Nullpunkts (d.h. der Stellung der Sensormasse ohne resultierende Kraft aus Sensorelektroden und Detektionselektroden) eine Verzerrung (Bias) der Beschleunigungsmessung mit dem Beschleunigungssensor bewirken. Dadurch wird die Verlässlichkeit des Beschleunigungssensors erhöht.

Eine Recheneinheit kann basierend auf Änderungen der neutralen Position und Änderungen der zur Aufhebung der Federkraft notwendigen Trimmspannung den Beschleunigungssensor auf Fehler überprüfen. Dadurch wird die Verlässlichkeit des Beschleunigungssensors erhöht.

Der Beschleunigungssensor kann ein mikro-elektro-mechanisches System (MEMS) sein. Dadurch wird es möglich, die oben erläuterten Vorteile auch in mikro-elektro-mechanischen Systemen zur Beschleunigungsmessung zu verwenden.

Diese und weitere Vorteile und Merkmale der Erfindung werden nachfolgend anhand von Beispielen unter Zuhilfenahme der begleitenden Figuren näher erläutert. Es zeigen:
- **Fig. 1A und 1B**: schematische Darstellungen eines Beschleunigungssensors gemäß einer Ausführungsform;
- **Fig. 2**: eine schematische Darstellung eines Beschleunigungssensors gemäß einer weiteren Ausführungsform;
- **Fig. 3**: eine schematische Darstellung eines Beschleunigungssensors gemäß einer weiteren Ausführungsform;
- **Fig. 4**: eine schematische Darstellung eines Beschleunigungssensors gemäß einer weiteren Ausführungsform;
- **Fig. 5**: eine schematische Darstellung der Entstehung einer Messverzerrung (Bias) in einem Beschleunigungssensor gemäß einer Ausführungsform; und
- **Fig. 6**: eine schematische Darstellung der Abhängigkeit einer Federhärte eines Beschleunigungssensors bei verschiedenen Trimmspannungen als Parameter.

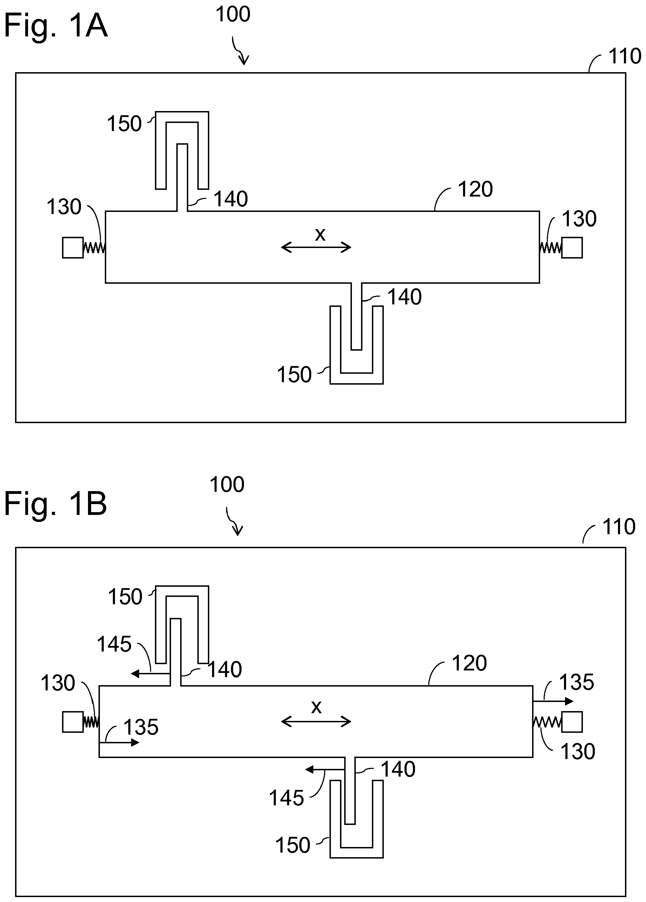

Fig. 1A und 1B zeigen in schematischer Darstellung einen Beschleunigungssensor 100 gemäß einer Ausführungsform.

Der Beschleunigungssensor 100 weist ein Substrat 110 auf. Über dem Substrat 110 ist eine Sensormasse 120 über Federelemente 130 entlang einer Bewegungsachse x beweglich gelagert. Die Federelemente 130 sind auf einer ersten Seite der Federelemente 130 fest mit dem Substrat 110 verbunden und auf einer zweiten Seite der Federelemente 130 fest mit der Sensormasse 120 verbunden. Die Federelemente 130 erlauben es der Sensormasse 120, entlang der Bewegungsachse x ausgelenkt zu werden. Zum Beispiel können die Federelemente 130 als Biege-Balkenfedern ausgebildet sein, die sich senkrecht zur Bewegungsachse x erstrecken und damit eine Bewegung allein entlang der Bewegungsachse x erlauben, wohingegen eine Bewegung senkrecht zur Bewegungsachse x nicht möglich ist. Die Federelemente 130 können aber auch jede andere Form aufweisen, die dazu führt, dass die Sensormasse 120 entlang der Bewegungsachse x ausgelenkt werden kann.

Erste Trimmelektroden 140 sind mit der Sensormasse 120 verbunden. Dabei sind die ersten Trimmelektroden 140 fest mit der Sensormasse 120 verbunden, z.B. können die Sensormasse 120 und die ersten Trimmelektroden 140 einstückig ausgebildet sein, d.h. die ersten Trimmelektroden 140 sind ein integraler Bestandteil der Sensormasse 120.

Zweite Trimmelektroden 150 sind mit dem Substrat 110 verbunden und den ersten Trimmelektroden 140 zugeordnet. Dabei sind die zweiten Trimmelektroden 150 fest mit dem Substrat 110 verbunden. Zum Beispiel können die zweiten Trimmelektroden 150 integraler Bestandteil des Substrats 110 sein.

Die Paarungen von ersten Trimmelektroden 140 und zweiten Trimmelektroden 150 sind derart ausgebildet, dass in einer Ruhelage der Sensormasse 120 keine von den ersten Trimmelektroden 140 und den zweiten Trimmelektroden 150 erzeugte Kraft auf die Sensormasse 120 wirkt, da die wie unten näher beschrieben zwischen den Trimmelektroden 140, 150 entstehende Kraftkomponenten kompensieren.

Die ersten Trimmelektroden 140 und die zweiten Trimmelektroden 150 müssen hierbei nicht symmetrisch an der Sensormasse 120 oder dem Substrat 110 angebracht sein. Zum Beispiel können sich sämtliche erste Trimmelektroden 140 auf einer Seite der Sensormasse 120 oder an einem Ende der Sensormasse 120 befinden.

Wie in Fig. 1B dargestellt, erzeugen die Federelemente 130 bei Auslenkung der Sensormasse 120 entlang der Bewegungsachse x eine Federkraft 135, die die Sensormasse 120 zurück in eine Ausgangslage bewegt, in der sich die von den einzelnen Federelementen 130 erzeugten Kräfte kompensieren oder in der diese Kräfte verschwinden (mechanischer Nullpunkt). Gleichzeitig wird durch Anlegen einer elektrischen Trimmspannung zwischen den ersten Trimmelektroden 140 und den zweiten Trimmelektroden 150 eine elektrostatische Kraft 145 auf die Sensormasse 120 erzeugt, die der Federkraft 135 entgegenwirkt, wie im Folgenden beschrieben wird.

Zum Beispiel können durch das Anlegen einer elektrische Trimmspannung zwischen den ersten Trimmelektroden 140 und den zweiten Trimmelektroden 150 die ersten Trimmelektroden 140 eine erste Ladung, z.B. eine negative Ladung, und die zweiten Trimmelektroden 150 eine der ersten Ladung entgegengesetzte zweite Ladung, z.B. eine positive Ladung, tragen. Dies führt dazu, dass eine resultierende elektrostatische Kraft zwischen den ersten Trimmelektroden 140 und den zweiten Trimmelektroden 150 entsteht, die bei Annäherung der ersten Trimmelektroden 140 an die zweiten Trimmelektroden 150 ansteigt.

So kann bei Auslenkung der Sensormasse 120 eine Kraft erzeugt werden, die die Sensormasse 120 über die fest mit der Sensormasse 120 verbundenen ersten Trimmelektroden 140 weiter auf die zweiten Trimmelektroden 150, die fest mit dem Substrat 110 verbunden sind, zubewegt. Diese elektrostatische Kraft 145 ist der durch die Federelemente 130 erzeugten Federkraft 135 entgegengesetzt. Dadurch wird die auf die Sensormasse 120 resultierende Kraft effektiv gemindert, was einer Verminderung der Federkonstanten des Beschleunigungssensors 100 entspricht.

Wie in den Fig. 1A und 1B gezeigt können die ersten Trimmelektroden 140 und die zweiten Trimmelektroden 150 derart ausgebildet sein, dass die elektrostatische Kraft 145 sich aus verschiedenen Kraftkomponenten zusammensetzt. In Fig. 1B entsteht zwischen den ersten Trimmelektroden 140 und den Seiten der zweiten Trimmelektroden 150, die den gestauchten Federelementen 130 zunächst liegen (in Fig. 1B die linke Seiten der zweiten Trimmelektroden), eine Kraftkomponente, die größer ist als die Kraftkomponente, die zwischen den ersten Trimmelektroden 140 und den rechten Seiten der zweiten Trimmelektroden 150 entsteht. Dies ist der Fall, da eine Entfernung zwischen den ersten Trimmelektroden 140 und den linken Seiten der zweiten Trimmelektroden 150 kleiner ist als eine Entfernung zwischen den ersten Trimmelektroden 140 und den rechten Seiten der zweiten Trimmelektroden 150.

Gemäß weiterer Ausführungsformen, in denen die ersten und zweiten Trimmelektroden anders ausgebildet sind, zum Beispiel als Elektrodenpaare eines Plattenkondensators, liegen die zweiten Trimmelektroden näher an den Federelementen 130 als die ersten Trimmelektroden, um bei einer Stauchung der Federelemente 130 aufgrund der geringer werdenden Entfernung zwischen ersten und zweiten Trimmelektroden die der Federkraft 135 entgegenwirkende elektrostatische Kraft 145 zu erzeugen. Da die Sensormasse 120 entlang der Bewegungsachse x in zwei Richtungen beweglich ist (in den Fig. 1A und 1B nach links und nach rechts), sind dann zumindest zwei Paare von ersten und zweiten Trimmelektroden nötig. Die resultierende elektrostatische Kraft 145 ergibt sich dann aus den Kräften zwischen den einzelnen Trimmelektrodenpaaren.

Es ist also möglich, über eine Trimmspannung, die zwischen den ersten Trimmelektroden 140 und den zweiten Trimmelektroden 150 anliegt, die Federhärte bzw. -steifigkeit des Beschleunigungssensors 100 frei einzustellen. Dadurch kann zum Beispiel erreicht werden, dass sich die Federkraft 135 und die elektrostatische Kraft 145 vollständig kompensieren, so dass bei Auslenkung der Sensormasse 120 keine rückstellende Kraft mehr vorhanden ist. Die elektrostatische Kraft 145 kann aber auch die Federkraft 135 überkompensieren, d.h. übersteigen, so dass bei einer nur kleinen Auslenkung der Sensormasse 120 die elektrostatische Kraft 145 die Sensormasse 120 zu einer großen Auslenkung verstärkt. Da dies zu einer sofortigen Übersteuerung der Sensormasse 120 führen kann, sollte der Beschleunigungssensor 100 in dieser Weise nur mit zusätzlicher Rückstellelektronik in einem geschlossenen Regelkreis betrieben werden.

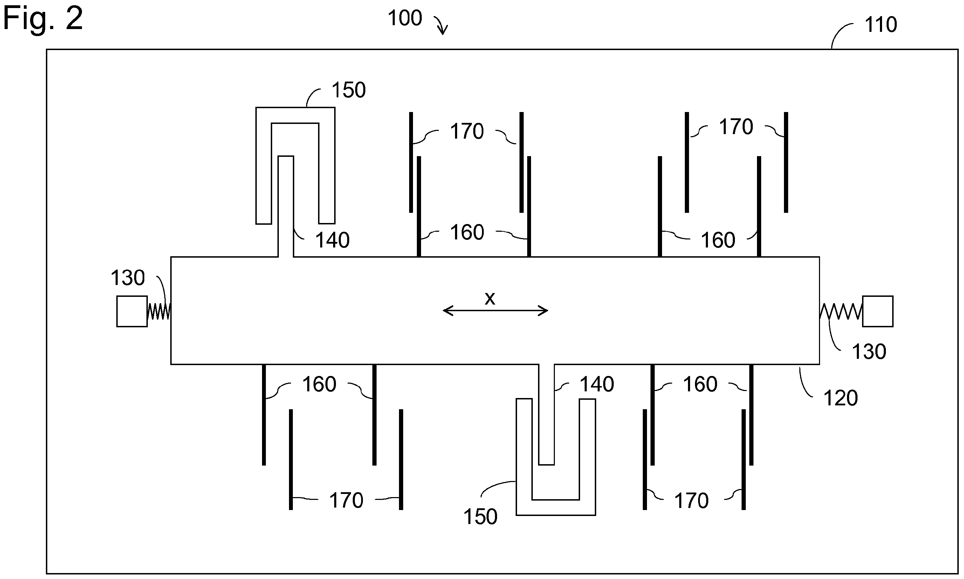

Fig. 2 zeigt den Beschleunigungssensor 100 mit schematisch dargestellten Sensorelektroden 160 zum Auslesen der Beschleunigung, die mit der Sensormasse 120 verbunden sind und denen schematisch dargestellte Detektionselektroden 170 zugeordnet sind, die mit dem Substrat 110 verbunden sind. Eine Spannung zwischen den Sensorelektroden 160 und den Detektionselektroden 170 kann von der Auslenkung der Sensormasse 120 entlang der Bewegungsachse x abhängig sein und damit ermöglichen, die Auslenkung der Sensormasse 120 zu bestimmen. Aus dieser Auslenkung kann dann wiederum die auf die Sensormasse 120 wirkende Beschleunigung bestimmt werden.

Nach Beendigung der Messung können die Sensorelektroden 160 und die Detektionselektroden 170 benutzt werden, die Sensormasse 120 wieder zurückzustellen.

Es ist aber auch möglich, die Spannung zwischen Sensorelektroden 160 und Detektionselektroden 170 derart zu regeln, dass die resultierende Kraft zwischen Sensorelektroden 160 und Detektionselektroden 170 die Beschleunigungskraft auf die Sensormasse 120 exakt kompensiert und damit zur Rückstellung der Sensormasse 120 dient. Dadurch verbleibt die Sensormasse 120 stets in derselben Position. Die zur Positionserhaltung notwendige Spannung zwischen Sensorelektroden 160 und Detektionselektroden 170 dient dann dazu, die Beschleunigung zu bestimmen.

Das Auslesen einer durch eine tatsächliche Positionsänderung der Sensormasse 120 erfolgten Spannungsänderung zwischen Sensorelektroden 160 und Detektionselektroden 170, wie sie auch in Fig. 2 gezeigt ist, erfolgt meist im Betrieb mittels eines offenen Regelkreises, wohingegen das Einstellen der Sensormasse 120 auf eine fixe Position mittels eines geschlossenen Regelkreises erfolgt.

Gemäß einer Ausführungsform ist mindestens ein Elektrodenpaar aus Sensorelektrode 160 und Detektionselektrode 170, bei dem sich bei einer Auslenkung entlang der Bewegungsachse x der Elektrodenspalt verringert, und mindestens ein Elektrodenpaar, bei dem sich bei der gleichen Auslenkung der Elektrodenspalt vergrößert, vorhanden. Gemäß einer weiteren Ausführungsform wird ein Teil der Sensorelektroden 160 und der Detektionselektroden 170 zur Beschleunigungsmessung verwendet, während ein anderer Teil zu Rückstellung der Sensormasse 120 benutzt wird.

Die Sensorelektroden 160 und die Detektionselektroden 170 müssen hierbei nicht symmetrisch an der Sensormasse 120 oder dem Substrat 110 angebracht sein. Zum Beispiel können sich sämtliche Sensorelektroden 160 auf einer Seite der Sensormasse 120 oder an einem Ende der Sensormasse 120 befinden.

Betreibt man den Beschleunigungssensor 100 mittels eines geschlossenen Regelkreises, so ist es von Vorteil, wenn die Position, die die Sensormasse 120 während der Messung einnehmen soll, frei bestimmbar ist. Aufgrund der durch die Federelemente 130 erzeugten Federkraft ist dies jedoch typischerweise nicht der Fall, da das System Federelemente 130 - Sensormasse 120 einen bestimmten mechanischen Nullpunkt aufweist, in dem sich sämtliche Federkräfte 135 kompensieren oder auf Null reduzieren. Da jedoch mittels der zwischen ersten Trimmelektroden 140 und zweiten Trimmelektroden 150 angelegten Trimmspannung die elektrostatische Kraft 145 erzeugt wird, die der Federkraft 135 entgegenwirkt oder diese sogar vollständig kompensiert, kann die Position der Sensormasse 120 im Betrieb mittels geschlossenem Regelkreis weitaus unabhängiger oder sogar vollständig frei von der Lage des mechanischen Nullpunktes bestimmt werden. Dies erlaubt es, den Beschleunigungssensor 100 auf einfachere Weise zu betreiben.

Zudem beeinflussen aufgrund der Kompensation der Federkraft 135 durch die elektrostatische Kraft 145 durch Temperaturschwankungen verursachte Relativbewegungen der einzelnen Komponenten des Beschleunigungssensors 100 die Messergebnisse des Beschleunigungssensors 100 weniger stark. Aufgrund von Temperaturschwankungen kann es zu einer Ausdehnung bzw. Kontraktion der einzelnen Bauelemente des Beschleunigungssensors 100 kommen. Dies wird in der Regel derart erfolgen, dass sich der mechanische Nullpunkt des Systems verschiebt, und führt bei nicht kompensierter Federkraft 135 zu einer zusätzlichen Verzerrung der Messergebnisse des Beschleunigungssensors 100. Da Ausdehnungen bzw. Kontraktionen aufgrund von Temperaturänderungen einem Hysterese-Effekt unterliegen, kann es ohne kompensierende Trimmspannung auch zu unterschiedlichen Messergebnissen bei gleicher Temperatur kommen. Dem kann durch eine nahezu vollständige Kompensation der Federkraft 135 durch die elektrostatische Kraft 145 begegnet werden, da das System dann schwächer oder gar nicht mehr auf eine Verschiebung des mechanischen Nullpunkts aufgrund von Temperaturschwankungen reagiert. Dadurch wird der Beschleunigungssensor 100 verlässlicher.

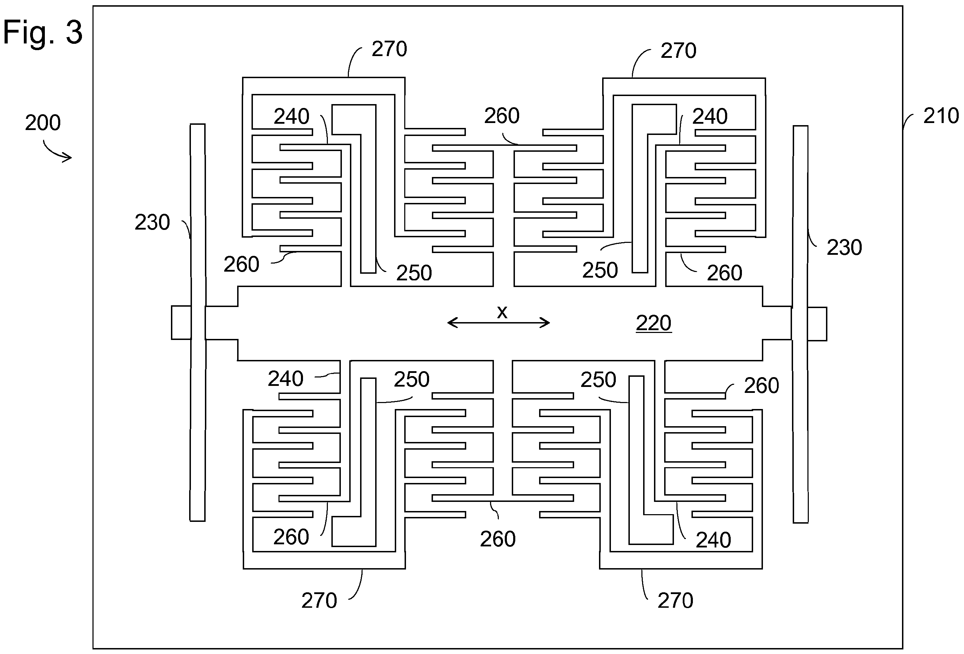

Fig. 3 zeigt eine Ausführungsform eines Beschleunigungssensors 200 als mikro-elektro-mechanisches System (MEMS) mit einem Substrat 210, einer Sensormasse 220, Federelementen 230, ersten Trimmelektroden 240, zweiten Trimmelektroden 250, Sensorelektroden 260 und Detektionselektroden 270.

Ein Teil der Sensorelektroden 260 des Beschleunigungssensors 200 ist dabei als erste Trimmelektrode 240 ausgebildet. In Fig. 3 sind dies diejenigen Sensorelektroden 260, die den Federelementen 230 zunächst liegen. Gemäß weiterer Ausführungsformen können dies aber auch andere Sensorelektroden 260 als erste Trimmelektroden 240 ausgebildet sein. Zudem sind die zweiten Trimmelektroden 250 derart zwischen den Sensorelektroden 260 und den Detektionselektroden 270 angeordnet, dass die Trimmspannung zwischen den ersten Trimmelektroden 240 und den zweiten Trimmelektroden 250 nicht nur zur Kompensation der von den Federelementen 230 erzeugten Federkraft dient, sondern auch eine Schwingung der Sensormasse 220 dämpft. Die zweiten Trimmelektroden 250 dienen also gleichzeitig als Dämpfungselektroden.

Ein Teil der ersten Trimmelektroden 240 ist dabei als Kammelektroden ausgebildet, deren Elektrodenfinger mit entsprechenden Elektrodenfingern der Detektionselektroden 270 verzahnt sind. Die von den Elektrodenfingern der Detektionselektroden 270 abgewandte Seite der ersten Trimmelektroden 240 bildet dabei mit den zweiten Trimmelektroden 250, die als Elektrodenplatten ausgebildet sind, einen Plattenkondensator. Die ersten Trimmelektroden 240 dienen also mit ihren Elektrodenfingern als Sensorelektroden 260 und mit ihrer Rückseite als Gegenplatte zu den Elektrodenplatten der zweiten Trimmelektroden 250. Damit ist es möglich, einzelnen Elektroden des Beschleunigungssensors 200 mehrere Aufgaben zuzuweisen. So dienen die ersten Trimmelektroden 240 sowohl zur Detektion der an dem Beschleunigungssensor 200 anliegenden Beschleunigung, als auch zur Einstellung der Federsteifigkeit des Beschleunigungssensors 200. Die zweiten Trimmelektroden 250 dienen sowohl der Dämpfung der durch die Beschleunigung des Beschleunigungssensors 200 ausgelösten Schwingung der Sensormasse 220 als auch der Einstellung der Federsteifigkeit des Beschleunigungssensors. Damit ist es möglich, die Anzahl der zum Betrieb des Beschleunigungssensors 200 nötigen Komponenten auf ein Mindestmaß zu reduzieren und den Beschleunigungssensor 200 kompakt und preiswert gestalten zu können.

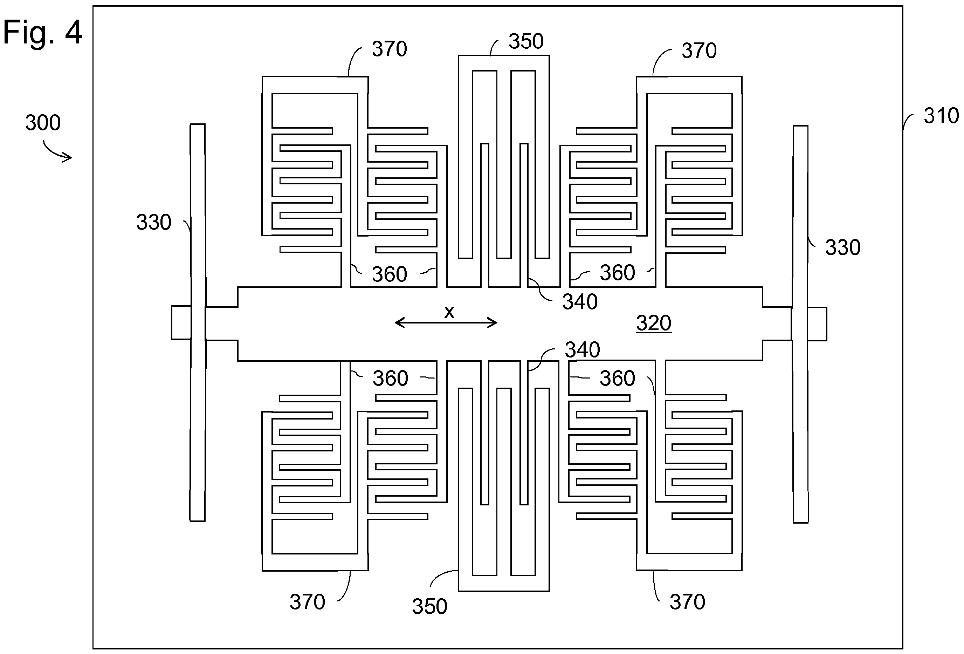

Gemäß eines in Fig. 4 gezeigten Beispiels eines MEMS-Beschleunigungssensors 300 ist es möglich, das Auslesen einer Beschleunigung von der Einstellung der Federhärte zu trennen. Der Beschleunigungssensor 300 weist dazu ein Substrat 310, eine Sensormasse 320, Federelemente 330, erste Trimmelektroden 340, zweite Trimmelektroden 350, Sensorelektroden 360 und Detektionselektroden 370 auf.

Dabei sind die ersten Trimmelektroden 340 symmetrisch zu einer zur Bewegungsachse x senkrechten Symmetrieachse an der Sensormasse angebracht und die zweiten Trimmelektroden symmetrisch zu der gleichen zur Bewegungsachse x senkrechten Symmetrieachse auf dem Substrat angebracht. Wie in Fig. 4 dargestellt, können die Sensorelektroden 360 und die Detektionselektroden 370 getrennt von den ersten Trimmelektroden 340 und den zweiten Trimmelektroden 350 angeordnet sein.

Durch die symmetrische Ausgestaltung der ersten Trimmelektroden 340 und der zweiten Trimmelektroden 350 wird gewährleistet, dass die Elektrodenspalte zwischen den Trimmelektroden 340, 350 völlig symmetrisch gestaltet werden können, wodurch keine resultierende Kraft auf die Sensormasse 320 entsteht, solange diese nicht ausgelenkt ist. Durch die Konzentration der Trimmelektroden 340, 350 an eine bestimmte Stelle der Sensormasse 320, z.B. in der Mitte der Sensormasse 320, kann zudem die Wirkung von Herstellungstoleranzen reduziert werden.

Es ist zudem möglich, Dämpfungselektroden, wie sie in Fig. 3 durch die zweiten Trimmelektroden 250 dargestellt wurden, separat in den Beschleunigungssensor 300 der Fig. 4 zu integrieren. Dies ermöglicht es, eine große Flexibilität bei Steuerung, Dämpfung, Auslesen und Trimmen des Beschleunigungssensors 300 mittels jeweils einzeln einstellbarer Auslese-, Dämpf- und Trimmspannungen erreichen zu können.

Die in Fig. 4 gezeigten Trimmelektroden 340, 350 sind als Elektrodenplatten ausgebildet und bilden Plattenkondensatoren. Dies erlaubt es, den Beschleunigungssensor 300 einfach und kostengünstig zu fertigen. Gemäß weiterer Beispiele können die als Plattenkondensatoren ausgebildeten ersten und zweiten Trimmelektroden 340, 350 auch an anderer Stelle an der Sensormasse 320 angebracht sein, z.B. am Rand der Sensormasse 320, auf nur einer Seite der Sensormasse 320 oder an einer beliebigen Stelle der Sensormasse 320.

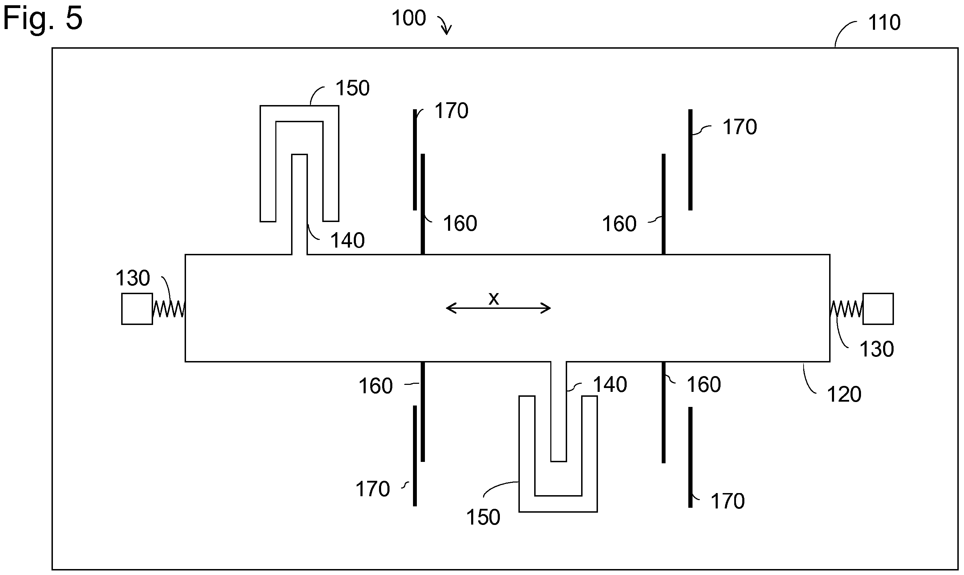

Fig. 5 zeigt den Beschleunigungssensor 100 im Fall, in dem eine mechanische Ruhelage der Sensormasse 120 sich, z.B. aufgrund von Fertigungstoleranzen, von der elektrischen Ruhelage (d.h. der Stellung der Sensormasse 120 ohne resultierende Kraft aus Sensorelektroden 160 und Detektionselektroden 170) der Sensormasse 120 unterscheidet. Neben der mechanischen Ruhelage und der elektrischen Ruhelage existiert zudem noch eine Trimmruhelage, in der keine Kräfte zwischen den ersten Trimmelektroden 140 und den zweiten Trimmelektroden 150 wirken, bzw. in der sich wirkende Kräfte kompensieren. Im Folgenden wird vereinfachend angenommen, dass die mechanische Ruhelage der Trimmruhelage entspricht.

Wie in Fig. 5 schematisch durch die gleiche Länge der Federelemente 130 und die mittige Position der ersten Trimmelektroden 140 zwischen den zweiten Trimmelektroden 150 dargestellt ist, befindet sich die Sensormasse 120 in der mechanischen Ruhelage (bzw. der Trimmruhelage), in der von den Federelementen 130 und den ersten und zweiten Trimmelektroden 140, 150 keine Kraft entlang der Bewegungsachse x auf die Sensormasse 120 ausgeübt wird.

Aufgrund von Fertigungstoleranzen tritt aber häufig der Fall auf, dass diese mechanische Ruhelage sich von der elektrischen Ruhelage, die durch die Positionen der Sensorelektroden 160 und der Detektionselektroden 170 bestimmt wird, unterscheidet. Dies ist in Fig. 5 schematisch durch unterschiedliche Abstände zwischen Sensorelektroden 160 und Detektionselektroden 170 dargestellt. Die Sensorelektroden 160 und die Detektionselektroden 170 sind in der Fig. 5 als einfache Elektrodenplatten gezeigt. Gemäß weiterer Ausführungsformen können sie aber auch die Form von Kammelektroden aufweisen, wie in den Fig. 2 und 3 gezeigt, oder eine Mischung aus Kammelektroden und Elektrodenplatten sein.

Obwohl sich also die Sensormasse 120 mechanisch in Ruhe befindet, wird eine Ausleseelektronik aus der relativen Position der Sensorelektroden 160 zu den Detektionselektroden 170 schließen, dass bereits eine Beschleunigung entlang der Bewegungsachse x vorliegt. Dies führt in der Regel zu einer Verzerrung (Bias) der Messergebnisse, die korrigiert werden muss, wenn genaue Messungen erzielt werden sollen.

Wie bereits oben erläutert, wird im Betrieb des Beschleunigungssensors 100 mittels geschlossenem Regelkreis die Sensormasse 120 in einer bestimmten Position gehalten. Durch Reduktion der Federhärte des gesamten Beschleunigungssystems mittels der zwischen den ersten und zweiten Trimmelektroden 140, 150 anliegenden Trimmspannung, kann diese Position freier gewählt werden und zum Beispiel derart eingestellt werden, dass das Messsystem aus Sensorelektroden 160 und Detektionselektroden 170 keine Verschiebung der Sensormasse 120 feststellen kann, d.h. der Beschleunigungssensor 100 kann z.B. an dem elektrischen Nullpunkt betrieben.

Gemäße einer weiteren Ausführungsform ist es aber auch möglich, den Beschleunigungssensor 100 mit der Sensormasse 120 in der Trimmruhelage zu betreiben. Dies ist auch möglich, wenn die mechanische Ruhelage, z.B. aufgrund von Fertigungstoleranzen, nicht mit der Trimmruhelage übereinstimmt. Mittels eines geschlossenen Regelkreises wird, wie oben beschrieben, eine Rückstellkraft durch die Sensorelektroden 160 und die Detektionselektroden 170 erzeugt, die die Sensormasse in der Trimmruhelage hält. Die Ablage zur elektrischen Ruhelage wird dann elektronisch verrechnet, um korrekte Messergebnisse zu erhalten.

Andererseits ist es möglich, über eine zwischen den Sensorelektroden 160 und den Detektionselektroden 170 anliegende Spannung die Position der Sensormasse 120 derart zu verändern, dass sie in einer neutralen Position gehalten wird, in der die zur weiteren Auslenkung benötigte Beschleunigung unabhängig von der Trimmspannung ist. Diese Position stimmt typischerweise mit dem mechanischen Nullpunkt überein. Die neutrale Position und die entsprechende Beschleunigung bilden zusammen ein charakteristisches Parameterpaar, mit deren Hilfe die Funktionsfähigkeit des Beschleunigungssensors 100 überprüft werden kann. Insbesondere kann mittels einer Recheneinheit die Abweichung des mechanischen Nullpunkts von dem elektrischen Nullpunkt bestimmt und dadurch die Verzerrung der Messergebnisse, d.h. der Bias, bestimmt und kompensiert werden.

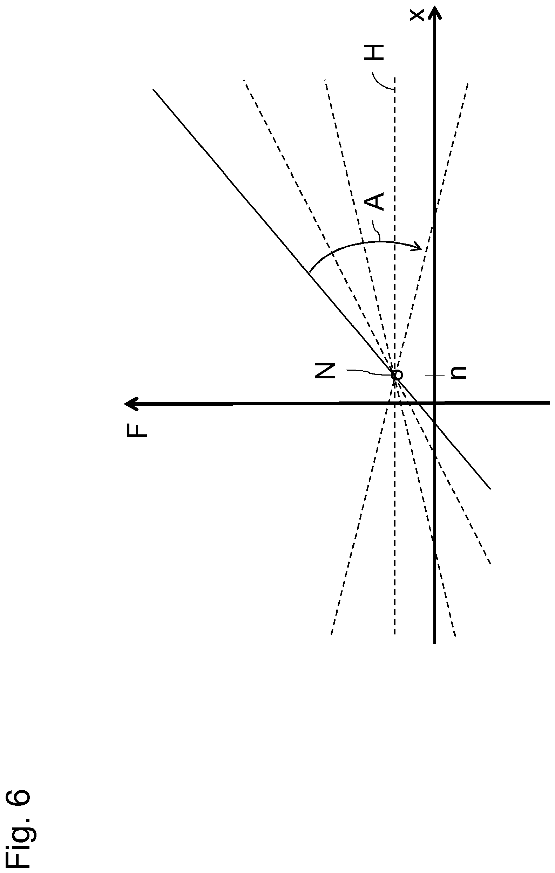

Dies ist zum Beispiel anhand des in Fig. 6 dargestellten Diagramms möglich. Fig. 6 zeigt die Abhängigkeit der zur Auslenkung der Sensormasse 120 nötigen Kraft F vom Ort x in Abhängigkeit von der Trimmspannung für kleine Auslenkungen. Liegt keine Trimmspannung an, so ergibt sich ein Abhängigkeitsverhältnis entsprechend der durchgezogenen Linie. Durch Erhöhung der Trimmspannung wird diese Linie um einen neutralen Punkt N entlang der Richtung des Pfeils A gedreht, was durch die gestrichelten Linien angedeutet ist. Bei einer bestimmten Trimmspannung kompensiert die erzeugte elektrostatische Kraft 145 die Federkraft 135 vollständig, wodurch die zur Auslenkung benötigte Kraft F unabhängig vom Ort x wird (gestrichelte horizontale Linie H in Fig. 6).

Der neutrale Punkt N, dessen x-Koordinate der neutralen Position entspricht, kann nun zur Bestimmung des Bias benutzt werden. Da nämlich die aufzuwendende Kraft F und der Ort x mit Bezug auf das Auslesesystem der Sensorelektroden 160 und Detektionselektroden 170 bestimmt werden, entspricht die Verschiebung zwischen mechanischem Nullpunkt und elektrischem Nullpunkt gerade dem x-Wert von N. Somit ist über die Detektion des neutralen Punkts N die Ermittlung bzw. die Kontrolle des Bias möglich.

Des Weiteren kann mittels des neutralen Punkts N der Beschleunigungssensor 100 auf Fehler überprüft werden. Dazu wird bei Inbetriebnahme des Beschleunigungssensors zunächst der neutrale Punkt N bestimmt. Ändert sich die Lage des neutralen Punkts N horizontal, bedeutet dies, dass die Elektrodenstruktur sich verändert hat, d.h. die Lage oder Form der Trimmelektroden 140, 150 ist instabil oder die elektrische Ruhelage der Sensor- und Detektionselektroden hat sich geändert. Verändert sich die Lage des neutralen Punkts N hingegen in vertikale Richtung, so ist die Elektrodenstruktur (Trimmelektroden 140, 150, Sensorelektroden 160, Detektionselektroden 170) stabil. Es liegt deshalb eine Veränderung aufgrund von mechanischen Krafteinwirkungen zugrunde, die etwa eine Versetzung in der Kristallstruktur der für den Beschleunigungssensor 100 verwendeten Materialien verursacht hat.

Es ist somit bei einem Beschleunigungssensor gemäß der Erfindung nicht nur möglich, die Federhärte bzw. -steifigkeit des Beschleunigungssensors frei einzustellen. Aufgrund dieser freie Einstellbarkeit können für den Betrieb des Beschleunigungssensors wichtige Parameter wie etwa die Lage des neutralen Punktes N bestimmt und die Verlässlichkeit des Beschleunigungssensors erhöht werden.

## Patentansprüche

1. Beschleunigungssensor (100, 200), mit
einer Sensormasse (120, 220), die mittels Federelementen (130, 230) entlang einer Bewegungsachse (x) beweglich über einem Substrat (110, 210) gelagert ist;
ersten Trimmelektroden (140, 240), die mit der Sensormasse (120, 220) verbunden sind;
und
zweiten Trimmelektroden (150, 250), die mit dem Substrat (110, 210) verbunden sind und den ersten Trimmelektroden (140, 240) zugeordnet sind; wobei durch die Federelemente (130, 230) bei Auslenkung der Sensormasse (120, 220) entlang der Bewegungsachse (x) eine Federkraft (135) auf die Sensormasse (120, 220) erzeugt wird;
durch Anlegen einer elektrischen Trimmspannung zwischen den ersten Trimmelektroden (140, 240) und den zweiten Trimmelektroden (150, 250) bei Auslenkung der Sensormasse (120, 220) eine elektrostatische Kraft (145) auf die Sensormasse (120, 220) erzeugt wird, die der Federkraft (135) entgegenwirkt;
ein Teil der ersten Trimmelektroden (240) als Kammelektroden zur Bildung von Sensorelektroden (260) ausgebildet ist und die zugeordneten zweiten Trimmelektroden (250) als Elektrodenplatten ausgebildet sind; und wobei
jeweilige Rückseiten der als Kammelektroden ausgebildeten ersten Trimmelektroden (240), die Elektrodenfinger der Kammelektroden tragen, mit den zugeordneten zweiten Trimmelektroden (250) Plattenkondensatoren bilden, die zur Erzeugung der elektrostatischen Kraft (145) eingerichtet sind.

2. Beschleunigungssensor (100, 200) nach Anspruch 1, mit
Sensorelektroden (160, 260) die mit der Sensormasse (120, 220) verbunden sind; und
Detektionselektroden (170, 270), die mit dem Substrat (110, 220) verbunden sind und die den Sensorelektroden (160, 260) zugeordnet sind, wobei
eine Auslenkung der Sensormasse (120, 220) entlang der Bewegungsachse (x) durch eine Veränderung einer elektrischen Detektionsspannung zwischen oder von elektrischen Ladungen auf den Sensorelektroden (160, 260) und den zugeordneten Detektionselektroden (170, 270) bestimmt werden kann.

3. Beschleunigungssensor (200) nach Anspruch 2, wobei
ein Teil der Sensorelektroden (260) als erste Trimmelektroden (240) ausgebildet ist; und wobei
die Trimmspannung zwischen den als erste Trimmelektroden (240) ausgebildeten Sensorelektroden (260) und den zweiten Trimmelektroden (250) die Auslenkung der Sensormasse (220) dämpft.

4. Beschleunigungssensor (200) nach einem der vorherigen Ansprüche, wobei
die ersten Trimmelektroden (240) symmetrisch zu einer zur Bewegungsachse (x) senkrechten Symmetrieebene an der Sensormasse (220) angebracht sind; und wobei
die zweiten Trimmelektroden (250) symmetrisch zu der zur Bewegungsachse (x) senkrechten Symmetrieachse auf dem Substrat (210) angebracht sind.

5. Beschleunigungssensor (100, 200) nach einem der vorherigen Ansprüche, wobei
die von den ersten Trimmelektroden (140, 240) und den zweiten Trimmelektroden (150, 250) erzeugte elektrostatische Kraft (145) gleich der von den Federelementen (130, 230) erzeugten Federkraft (135) ist.

6. Beschleunigungssensor (200) nach einem der vorherigen Ansprüche, wobei
ein Teil der ersten Trimmelektroden (240) als Elektrodenplatten ausgebildet ist; und wobei
die ersten Trimmelektroden (240), die als Elektrodenplatten ausgebildet sind, und die zugeordneten zweiten Trimmelektroden (250) Plattenkondensatoren bilden.

7. Beschleunigungssensor (100, 200) nach einem der Ansprüche 2 bis 6, wobei
die Sensormasse (120, 220) durch Einstellen der Detektionsspannung in einer neutralen Position gehalten wird, in der die zur weiteren Auslenkung benötigte Beschleunigung unabhängig von der Trimmspannung ist.

8. Beschleunigungssensor (100, 200) nach Anspruch 7, wobei
eine Recheneinheit aus der neutralen Position eine Abweichung einer ersten Stellung der Sensormasse (120, 220), in der keine Federkraft auf die Sensormasse (120, 220) wirkt, von einer zweiten Stellung der Sensormasse (120, 220) bestimmt, in der keine von den Sensorelektroden und Detektionselektroden erzeugte Kraft auf die Sensormasse (120, 220) wirkt.

9. Beschleunigungssensor (100, 200) nach einem der Ansprüche 7 und 8, wobei
eine Recheneinheit basierend auf Änderungen der neutralen Position und Änderungen der zur Aufhebung der Federkraft notwendigen Trimmspannung den Beschleunigungssensor (100, 200) auf Fehler überprüft.

10. Beschleunigungssensor (100, 200) nach einem der vorherigen Ansprüche, wobei der Beschleunigungssensor (100, 200) ein mikro-elektro-mechanisches System ist.

## Claims

1. An acceleration sensor (100, 200) having
a sensor mass (120, 220) which is mounted by means of spring elements (130, 230) so as to be movable along a movement axis (x) over a substrate (110, 210);
first trim electrodes (140, 240) which are connected to the sensor mass (120, 220); and
second trim electrodes (150, 250) which are connected to the substrate (110, 210) and are associated with the first trim electrodes (140, 240), wherein
when the sensor mass (120, 220) is deflected along the movement axis (x), a spring force (135) acting on the sensor mass (120, 220) is generated by the spring elements (130, 230);
when the sensor mass (120, 220) is deflected, an electrostatic force (145) acting on the sensor mass (120, 220), which counteracts the spring force (135), is generated by application of an electrical trim voltage between the first trim electrodes (140, 240) and the second trim electrodes (150, 250);
a part of the first trim electrodes (240) is formed as comb electrodes for forming sensor electrodes (260) and the associated second trim electrodes (250) are formed as electrode plates; and wherein
respective back sides of the first trim electrodes (240) formed as comb electrodes, which bear electrode fingers of the comb electrodes, form, together with the associated second trim electrodes (250), plate capacitors which are configured to generate the electrostatic force (145).

2. The acceleration sensor (100, 200) according to claim 1, having
sensor electrodes (160, 260) which are connected to the sensor mass (120, 220); and
detection electrodes (170, 270) which are connected to the substrate (110, 210) and are associated with the sensor electrodes (160, 260), wherein
a deflection of the sensor mass (120, 220) along the movement axis (x) can be determined through a change of an electrical detection voltage between or of electrical charges on the sensor electrodes (160, 260) and the associated detection electrodes (170, 270).

3. The acceleration sensor (200) according to claim 2, wherein
a part of the sensor electrodes (260) is formed as first trim electrodes (240); and wherein
the trim voltage between the sensor electrodes (260) formed as first trim electrodes (240) and the second trim electrodes (250) dampens the deflection of the sensor mass (220).

4. The acceleration sensor (200) according to any one of the preceding claims, wherein
the first trim electrodes (340) are arranged symmetrically to a plane of symmetry perpendicular to the movement axis (x) on the sensor mass (220); and wherein
the second trim electrodes (250) are arranged symmetrically to the axis of symmetry perpendicular to the movement axis (x) on the substrate (210).

5. The acceleration sensor (100, 200) according to anyone of the preceding claims, wherein
the electrostatic force (145) generated by the first trim electrodes (140, 240) and the second trim electrodes (150, 250) is equal to the spring force (135) generated by the spring elements (130, 230).

6. The acceleration sensor (200) according to any one of the preceding claims, wherein
a part of the first trim electrodes (240) is formed as electrode plates; and wherein
the first trim electrodes (240), which are formed as electrode plates, and the associated second trim electrodes (250) form plate capacitors.

7. The acceleration sensor (100, 200) according to any one of claims 2 to 6, wherein
the sensor mass (120, 220), through setting of the detection voltage, is kept in a neutral position in which the acceleration required for further deflection is independent of the trim voltage.

8. The acceleration sensor (100, 200) according to claim 7, wherein
a computing unit determines, from the neutral position, a deviation of a first position of the sensor mass (120, 220) in which no spring force acts on the sensor mass (120, 220), from a second position of the sensor mass (120, 220) in which no force generated by the sensor electrodes and detection electrodes acts on the sensor mass (120, 220).

9. The acceleration sensor (100, 200) according to any one of claims 7 or 8, wherein
a computing unit, based on changes of the neutral position and changes of the trim voltage required to cancel the spring force, checks the acceleration sensor (100, 200) for errors.

10. The acceleration sensor (100, 200) according to any one of the preceding claims, wherein the acceleration sensor (100, 200) is a micro-electro-mechanical system.

## Revendications

1. Capteur d'accélération (100, 200) avec
une masse de capteur (120, 220) qui est montée, mobile à l'aide d'éléments à ressort (130, 230) le long d'un axe de déplacement (x), sur un substrat (110, 210) ;
des premières électrodes d'ajustage (140, 240) qui sont reliées à la masse de capteur (120, 220) ; et
des deuxièmes électrodes d'ajustage (150, 250) qui sont reliées au substrat (110, 210) et qui sont associées aux premières électrodes d'ajustage (140, 240) ;
une force de ressort (135) étant produite sur la masse de capteur (120, 220) par les éléments à ressort (130, 230) lors d'une déviation de ladite masse de capteur (120, 220) le long de l'axe de déplacement (x) ;
une force électrostatique (145) qui agit à l'encontre de la force de ressort (135) étant produite sur la masse de capteur (120, 220) par l'application d'une tension électrique d'ajustage entre les premières électrodes d'ajustage (140, 240) et les deuxièmes électrodes d'ajustage (150, 250), lors d'une déviation de la masse de capteur (120, 220) ;
une partie des premières électrodes d'ajustage (240) étant conçues comme des électrodes en forme de peignes pour former des électrodes de capteur (260), et les deuxièmes électrodes d'ajustage (250) associées étant conçues comme des plaques d'électrodes ; et
les faces arrière des premières électrodes d'ajustage (240) qui sont conçues comme des électrodes en forme de peignes et qui portent des dents de ces dernières, formant avec les deuxièmes électrodes d'ajustage (250) associées des condensateurs à plaques qui sont installés pour produire la force électrostatique (145).

2. Capteur d'accélération (100, 200) selon la revendication 1, avec des électrodes de capteur (160, 260) qui sont reliées à la masse de capteur (120, 220) ; et
des électrodes de détection (170, 270) qui sont reliées au substrat (110, 220) et qui sont associées aux électrodes de capteur (160, 260),
une déviation de la masse de capteur (120, 220) le long de l'axe de déplacement (x) pouvant être définie grâce à une variation d'une tension de détection électrique entre ou des charges électriques sur les électrodes de capteur (160, 260) et les électrodes de détection (170, 270) associées.

3. Capteur d'accélération (200) selon la revendication 2,
une partie des électrodes de capteur (260) étant conçues comme des premières électrodes d'ajustage (240) ;
et la tension d'ajustage entre les électrodes de capteur (260) conçues comme des premières électrodes d'ajustage (240) et les deuxièmes électrodes de capteur (250) atténuant la déviation de la masse de capteur (220).

4. Capteur d'accélération (200) selon l'une des revendications précédentes,
les premières électrodes d'ajustage (240) étant montées sur la masse de capteur (220) symétriquement par rapport à un plan de symétrie perpendiculaire à l'axe de déplacement (x) ; et
les deuxièmes électrodes d'ajustage (250) étant montées sur le substrat (210) symétriquement par rapport à un plan de symétrie perpendiculaire à l'axe de déplacement (x)

5. Capteur d'accélération (100, 200) selon l'une des revendications précédentes,
la force électrostatique (145) produite par les premières électrodes d'ajustage (140, 240) et les deuxièmes électrodes d'ajustage (150, 250) étant égale à la force de ressort (135) produite par les éléments à ressort (130, 230) .

6. Capteur d'accélération (200) selon l'une des revendications précédentes,
une partie des premières électrodes d'ajustage (240) étant conçues comme des plaques d'électrodes ; et
les premières électrodes d'ajustage (240) qui sont conçues comme des plaques d'électrodes et les deuxièmes électrodes d'ajustage (250) associées étant conçues comme des condensateurs à plaques.

7. Capteur d'accélération (100, 200) selon l'une des revendications 2 à 6,
la masse de capteur (120, 220) étant maintenue, grâce à un réglage de la tension de détection, dans une position neutre dans laquelle l'accélération nécessaire à la poursuite de la déviation est indépendante de la tension d'ajustage.

8. Capteur d'accélération (100, 200) selon la revendication 7,
une unité de calcul définissant, à partir de la position neutre, un écart entre une première position de la masse de capteur (120, 220) dans laquelle aucune force de ressort n'agit sur la masse de capteur (120, 220), et une deuxième position de la masse de capteur (120, 220) dans laquelle aucune force produite par les électrodes de capteur et les électrodes de détection n'agit sur la masse de capteur (120, 220).

9. Capteur d'accélération (100, 200) selon l'une des revendications 7 et 8,
une unité de calcul, sur la base de variations de la position neutre et de variations de la tension d'ajustage nécessaire pour neutraliser la force de ressort, examinant la présence d'erreurs dans le capteur d'accélération (100, 200) .

10. Capteur d'accélération (100, 200) selon l'une des revendications précédentes,
ledit capteur d'accélération (100, 200) étant un système micro-électromécanique.
